# EUROPEAN PATENT APPLICATION

(11) **EP 2 637 231 A1**
(43) Date of publication of application: **11.09.2013**
(21) Application number: 12194304.7
(22) Date of filing: 26.11.2012
(51) Int. Cl.: H01L 51/52

(54) **Method of preparing organic light-emitting device**

(30) Priority: 05.03.2012 KR 20120022518
(71) Applicant: Samsung Display Co., Ltd., Yongin-City, Gyeonggi-Do (KR)
(72) Inventor: Park, Jin-Woo, Asan-City Chungcheongnam-Do 336-741 (KR)
(74) Representative: Mounteney, Simon James

(57) **Abstract**

A method of preparing an organic light-emitting device including: forming an organic emission unit (13) on a substrate (11); and forming a thin film encapsulation layer (20) including at least one inorganic layer including a low temperature viscosity transition (LVT) inorganic material, the forming the thin film encapsulation layer including forming the at least one inorganic layer, and the forming the at least one inorganic layer including: forming a pre-inorganic layer (23) including the LVT inorganic material on the organic emission unit (13) by heating a source including the LVT inorganic material using plasma in a vacuum and depositing the LVT inorganic material or ions of the LVT inorganic material separated from the source on the organic emission unit (13); and applying a healing process to the pre-inorganic layer (23) at a temperature greater than a viscosity transition temperature of the LVT inorganic material and an organic light-emitting device prepared by this method.

## Description

### BACKGROUND

### 1. Field

Aspects of embodiments of the present invention relate to a method of preparing an organic light-emitting device.

### 2. Description of the Related Art

Organic light-emitting devices, which are self-emitting devices, have advantages such as a wide viewing angle, excellent contrast, quick response, high brightness, excellent driving voltage characteristics, and can provide multicolored images.

The organic light-emitting device includes an organic emission unit including a first electrode, an organic layer, and a second electrode. Since the organic emission unit is vulnerable to an external environment, such as oxygen and moisture, a sealing structure that seals the organic emission unit from the external environment is required.

Meanwhile, there is a need to develop a thin organic light-emitting device and/or a flexible organic light-emitting device.

### SUMMARY

According to an aspect of embodiments of the present invention, a method of preparing an organic light-emitting device is provided in which the organic light-emitting device includes a thin film encapsulation layer having excellent sealing characteristics against an external environment and flexibility and the organic light-emitting device produced by said process.

According to an embodiment of the present invention, a method of preparing an organic light-emitting device includes: forming an organic emission unit on a substrate; and forming a thin film encapsulation layer including at least one inorganic layer including a low temperature viscosity transition (LVT) inorganic material, the forming the thin film encapsulation layer including forming the at least one inorganic layer, and the forming the at least one inorganic layer includes: forming a pre-inorganic layer including the LVT inorganic material on the organic emission unit by heating a source including the LVT inorganic material using plasma in a vacuum and depositing the LVT inorganic material or ions of the LVT inorganic material separated from the source on the organic emission unit; and applying a healing process to the pre-inorganic layer at a temperature greater than a viscosity transition temperature of the LVT inorganic material.

The forming the pre-inorganic layer may preferably include applying a negative potential to the substrate.

The viscosity transition temperature of the LVT inorganic material may preferably be a minimum temperature capable of providing fluidity to the LVT inorganic material.

The viscosity transition temperature of the LVT inorganic material may preferably be less than a lowest temperature of denaturation temperatures of materials contained in the organic emission unit.

The LVT inorganic material may preferably include a tin oxide.

The LVT inorganic material may preferably further include at least one selected from the group consisting of phosphorus oxide, boron phosphate, tin fluoride, niobium oxide, and tungsten oxide.

The LVT inorganic material may preferably include SnO; SnO and P₂O₆; SnO and BPO₄; SnO, SnF₂, and P₂O₅; SnO, SnF₂, P₂O₅, and NbO; or SnO, SnF₂, P₂O₅, and WO₃.

The applying the healing process may preferably be performed by heat-treating the pre-inorganic layer at a temperature in the range of the viscosity transition temperature of the LVT inorganic material to a lowest temperature of denaturation temperatures of materials contained in the organic emission unit.

The applying the healing process may preferably be performed by heat-treating the pre-inorganic layer at a temperature of 80°C to 132°C for 1 to 3 hours.

The applying the healing process may preferably be performed in a vacuum or in an inert gas atmosphere.

The applying the healing process may preferably include scanning the pre-inorganic layer while irradiating a laser beam to the pre-inorganic layer.

The forming the at least one inorganic layer may preferably further include applying another healing process by using chemical treatment, plasma treatment, hot chamber treatment including oxygen, or hot chamber treatment including oxygen and moisture.

The forming the thin film encapsulation layer may preferably further include forming at least one organic layer of the thin film encapsulation layer, the at least one organic layer including a polymer.

The forming the at least one organic layer may preferably include providing a curable precursor, and curing the curable precursor. The providing the curable precursor may preferably be performed by using a flash evaporator. The curing the curable precursor may preferably be performed by using at least one of UV rays, infrared rays, or laser beams.

The thin film encapsulation layer may preferably include one organic layer and one inorganic layer, and the organic layer and the inorganic layer may preferably be sequentially stacked on the organic emission unit.

The thin film encapsulation layer may preferably include one organic layer and one inorganic layer, and the inorganic layer and the organic layer may preferably be sequentially stacked on the organic emission unit.

The thin film encapsulation layer may preferably include two organic layers including first and second organic layers, and one inorganic layer, and the first organic layer, the inorganic layer, and the second organic layer may preferably be sequentially stacked on the organic emission unit.

The thin film encapsulation layer may preferably include one organic layer, and two inorganic layers including first and second inorganic layers, and the first inorganic layer, the organic layer, and the second inorganic layer may preferably be sequentially stacked on the organic emission unit.

An environmental element may preferably be covered with the thin film encapsulation layer.

The present invention also provides an organic light-emitting device produced by the above described processes.

### BRIEF DESCRIPTION OF THE DRAWINGS

The above and other features and aspects of the present invention will become more apparent by describing in further detail some embodiments thereof with reference to the attached drawings in which:

FIGS. 1A to 1D are schematic diagrams illustrating a method of preparing an organic light-emitting device according to an embodiment of the present invention;

FIG. 2 is a schematic view of a device used to form a pre-inorganic layer of an organic light-emitting device according to an embodiment of the present invention;

FIGS. 3A to 3D are schematic diagrams illustrating a method of preparing an organic light-emitting device according to another embodiment of the present invention; and

FIGS. 4 to 6 are schematic views of organic light-emitting devices prepared according to methods of preparing an organic light-emitting device according to embodiments of the present invention.

### DETAILED DESCRIPTION

The present invention will be described more fully hereinafter with reference to the accompanying drawings, in which some embodiments of the invention are shown. However, embodiments of the present invention may be embodied in different forms and should not be construed as limited to the embodiments illustrated and set forth herein. Rather, these embodiments are provided by way of example for understanding of the invention and to convey the scope of the invention to those skilled in the art. As those skilled in the art would realize, the described embodiments may be modified in various ways, all without departing from the spirit or scope of the present invention. As used herein, the term "and/or" includes any and all combinations of one or more of the associated listed items. Expressions such as "at least one of," when preceding a list of elements, modify the entire list of elements and do not modify the individual elements of the list.

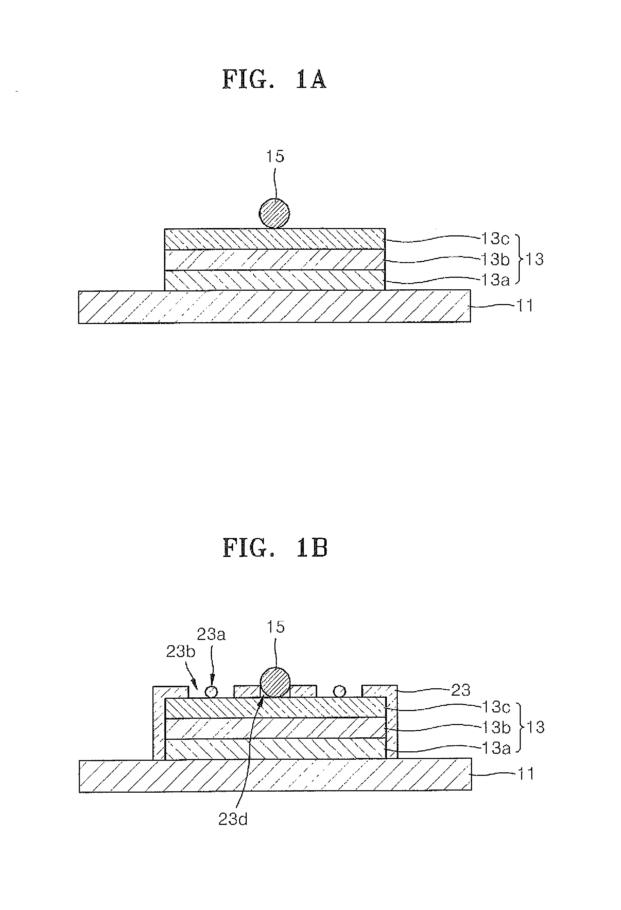

As shown in FIG. 1A, an organic emission unit 13 is formed on a substrate 11. The organic emission unit 13 may preferably have a structure including a first electrode 13a, an organic layer 13b, and a second electrode 13c which are sequentially stacked.

The substrate 11 may preferably be any suitable substrate to be used in an organic light-emitting device, and, in one embodiment, may preferably be a glass substrate or a transparent plastic substrate with excellent mechanical strength, thermal stability, transparency, surface smoothness, ease of handling, and water resistance. The substrate 11 may preferably be a flexible substrate that may preferably be bent. In one embodiment, a bending radius of the substrate 11 may preferably be 10 cm or less.

The first electrode 13a may preferably be formed by depositing or sputtering a material used to form the first electrode 13a on the substrate 11. When the first electrode 13a constitutes an anode, the material used to form the first electrode 13a may preferably be a high work function material so as to facilitate hole injection. The first electrode 13a may preferably be a reflective, semi-transmissive, or transmissive electrode. Transparent and conductive materials, such as indium tin oxide (ITO), indium zinc oxide (IZO), tin oxide (SnO₂), and zinc oxide (ZnO), may preferably be used to form the first electrode 13a. The first electrode 13a may preferably also be formed as a reflective electrode using magnesium (Mg), aluminum (Al), aluminum-lithium (Al-Li), calcium (Ca), magnesium-indium (Mg-In), magnesium-silver (Mg-Ag), or the like.

The first electrode 13a may preferably have a single-layered or a multi-layered structure. For example, the first electrode 13a may preferably have a triple-layered structure of ITO/Ag/ITO, but is not limited thereto.

The organic layer 13b is preferably formed on the first electrode 13a.

The organic layer 13b may preferably include at least one layer selected from the group consisting of a hole injection layer, a hole transport layer, a functional layer having both hole injecting and hole transporting capabilities, a buffer layer, an electron blocking layer, an emission layer, a hole blocking layer, an electron transport layer, and an electron injection layer.

In one embodiment, for example, the organic layer 13b may preferably include at least one of compounds 301, 311, and 321 below.

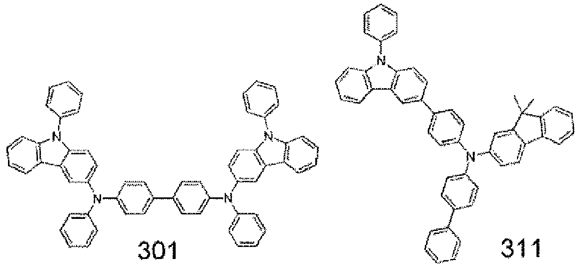

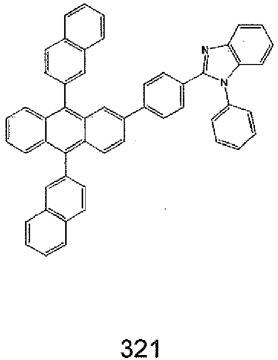

The second electrode 13c is disposed on the organic layer 13b. The second electrode 13c may preferably be a cathode, which is an electron injecting electrode. A metal used to form the second electrode 13c may preferably be a metal, an alloy, or an electrically conductive compound, which has a low work function, or a mixture thereof. In one embodiment, for example, the second electrode 13c may preferably be a reflective, semi-transmissive, or transmissive electrode by forming a thin film using lithium (Li), magnesium (Mg), aluminum (Al), aluminum-lithium (Al-Li), calcium (Ca), magnesium-indium (Mg-In), magnesium-silver (Mg-Ag), or the like. In one embodiment, in order to manufacture a top-emission type organic light-emitting device, a transmissive electrode formed of ITO or IZO may preferably be used, and various modifications may be applied thereto.

Although not shown in FIG. 1A, the organic emission unit 13 includes one pixel circuit per each pixel, and the pixel circuit may preferably include at least one thin film transistor (TFT) (not shown) and a capacitor (not shown). The first electrode 13a may preferably be electrically connected to the TFT.

In one embodiment, the first electrode 13a may preferably be patterned in each pixel independent from one another, and the second electrode 13c may preferably be a common electrode covering all of the pixels.

In a bottom-emission type organic light-emitting display device in which an image is formed toward the substrate 11, emission efficiency toward the substrate 11 may preferably be increased by forming the second electrode 13c relatively thick.

In a top-emission type organic light-emitting display device in which an image is formed toward the organic layer 13b, the second electrode 13c may preferably be a semi-reflective layer by forming the second electrode 13c relatively thin, or the second electrode 13c may preferably be formed of a transparent conductive material, and the first electrode 13a may preferably further include a reflective layer.

Although not shown in FIG. 1A, a protective layer may preferably be formed on the second electrode 13c. The protective layer may preferably be formed of LiF, lithium quinolate, Alq3, or the like.

After the organic emission unit 13 is formed, an environmental element 15 is on the organic emission unit 13. The environmental element 15 is an impurity particle that exists or is generated when the organic emission unit 13 is formed, and may be, for example, a microparticle from an external environment (e.g., dust existing in the external environment) or a microparticle of a material used to form the organic emission unit 13 and remaining on the organic emission unit 13 (e.g., a microparticle formed of a material used to form the second electrode 13c and remaining after the second electrode 13c is formed). The environmental element 15 may include various organic materials, inorganic materials, organic/inorganic complexes, and the like. The environmental element 15 cannot be removed by using a known method, such as a wet process (e.g., washing) after the organic emission unit 13 is formed.

For example, the environmental element 15 may be a particle having an average particle diameter of 5 µm or less, such as an average particle size of 1 µm to 5 µm, but is not limited thereto.

In FIG. 1A, the environmental element 15 is depicted as one spherical particle.

A low temperature viscosity transition (LVT) inorganic material is provided onto the organic emission unit 13 on which the environmental element 15 is formed to form a pre-inorganic layer 23 including the LVT inorganic material, as shown in FIG. 1B.

The LVT inorganic material is an inorganic material having a low viscosity transition temperature.

As used herein, the "viscosity transition temperature" is not a temperature where the phase of the LVT inorganic material is completely changed from solid to liquid, but is a minimum temperature where the LVT inorganic material has fluidity. In an embodiment of the present invention the LVT inorganic material has fluidity at a temperature of 80°C or greater, such as 80°C to 135°C, 80°C to 132°C, 80°C to 120°C, or 100°C to 120°C. By "fluidity" it is meant the ability to flow readily, i.e. once the LVT inorganic material is heated to the above temperature range it is able to flow readily.

The viscosity transition temperature of the LVT inorganic material may preferably be less than a denaturation temperature of a material contained in the organic emission unit 13. By "denature" it is meant destroy the characteristic properties of by heat that disrupts its molecular conformation.

For example, the viscosity transition temperature of the LVT inorganic material may preferably be less than a lowest temperature of the denaturation temperatures of the materials contained in the organic emission unit 13.

The denaturation temperature of the material contained in the organic emission unit 13 refers to a temperature capable of causing chemical and/or physical denaturation in the material contained in the organic emission unit 13, and the organic emission unit 13 may preferably have a plurality of denaturation temperatures according to the type and number of materials contained therein.

The "viscosity transition temperature of the LVT inorganic material" and the denaturation temperature of the material contained in the organic emission unit 13 may preferably be indicated by a glass transition temperature Tg of the LVT inorganic material and the organic material contained in the organic layer 13b of the organic emission unit 13. The Tg for each material may preferably be measured by performing thermogravimetric analysis (TGA) on the LVT inorganic material, and on the organic material contained in the organic layer 13b of the organic emission unit 13.

For example, the Tg may preferably be obtained from thermal analysis of the material contained in the organic emission unit 13 by using TGA and differential scanning calorimetry (DSC) in an N₂ atmosphere at a temperature ranging from room temperature to 600°C (10°C/min) for TGA, at a temperature ranging from room temperature to 400°C for DSC (Pan Type: Pt Pan in disposable Al Pan (TGA), disposable Al pan (DSC)), the conditions for which would be understood by one of ordinary skill in the art. Preferably, the Tg is obtained using TGA.

The denaturation temperature of the material contained in the organic emission unit 13 may preferably be, but is not limited to, higher than or equal to 130°C, and may preferably be efficiently measured via TGA analysis of the material contained in the organic emission unit 13 as described above. The denaturation temperature must be consistent with the viscosity transition temperature, i.e. although the ranges given overlap, the denaturation temperature is always greater than the viscosity transition temperature. Preferably, the denaturation temperature may be between 130°C to 200°C, for example between 130°C to 175°C

The lowest temperature of the denaturation temperatures of the materials contained in the organic emission unit 13 may preferably be 130°C to 140°C. For example, the lowest temperature of the denaturation temperatures of the materials contained in the organic emission unit 13 may preferably be, but is not limited to, 132°C, and may preferably be measured by measuring Tg of the material contained in the organic emission unit 13 via TGA analysis of the material as described above, and choosing the lowest Tg.

In one embodiment, the viscosity transition temperature of the LVT inorganic material may preferably be 80°C or greater, such as 80°C to 135°C or 80°C to 132°C, but is not limited thereto and must be consistent with the above denaturation temperature. For example, the viscosity transition temperature of the LVT inorganic material may preferably be 80°C to 120°C, or 100°C to 120°C, but is not limited thereto. For example, the viscosity transition temperature of the LVT inorganic material may preferably be 110°C.

The LVT inorganic material may preferably be a single compound or a mixture of at least two compounds.

The LVT inorganic material may preferably include a tin oxide, such as SnO or SnO₂.

In one embodiment, the LVT inorganic material includes SnO, and the content of SnO may preferably be 20% by weight to 100% by weight.

In one embodiment, the LVT inorganic material may preferably further include at least one selected from the group consisting of phosphorus oxide (e.g., P₂O₅), boron phosphate (BPO₄), tin fluoride (e.g., SnF₂), niobium oxide (e.g., NbO), and tungsten oxide (e.g., WO₃), but is not limited thereto.

In one embodiment, the LVT inorganic material may preferably include: SnO; SnO and P₂O₅; SnO and BPO₄, SnO, SnF₂, and P₂O₅; SnO, SnF₂, P₂O₅, and NbO; or SnO, SnF₂, P₂O₅, and WO₃, but is not limited thereto.

In one embodiment, the LVT inorganic material may preferably include between 15-100wt% SnO. In one embodiment, the LVT inorganic material may preferably include between 15-90wt% SnO or 20-50wt% SnO. In one embodiment, the LVT inorganic material may preferably include between 10-30wt% P₂O₅, optionally 12-22wt% P₂O₅. In one embodiment, the LVT inorganic material may preferably include between 2-20wt% BPO₄, optionally 5-15wt% BPO₄. In one embodiment, the LVT inorganic material may preferably include between 20-60wt% SnF₂, optionally 30-55 wt% SnF₂. In one embodiment, the LVT inorganic material may preferably include between 0.5-10wt% NbO, optionally 1-5 wt% NbO. In one embodiment, the LVT inorganic material may preferably include between 0.5-10wt% WO₃, optionally 1-5wt% WO₃. In one embodiment, the LVT inorganic material may preferably include: SnO (100wt%); SnO (80wt%) and P₂O₅ (20wt%); SnO (90wt%) and BPO₄ (10wt%); SnO (20-50wt%), SnF₂ (30-60wt%), and P₂O₅ (10-30wt%), where the weight percent of the sum of SnO, SnF₂, and P₂O₅ is 100wt%; SnO (20-50wt%), SnF₂ (30-60wt%), P₂O₅ (10-30wt%), and NbO (1-5wt%), where the weight percent of the sum of SnO, SnF₂, P₂O₅, and NbO is 100wt%; or SnO (20-50wt%), SnF₂ (30-60wt%), P₂O₅ (10-30wt%), and WO₃ (1-5wt%), where the weight percent of the sum of SnO, SnF₂, P₂O₅, and WO₃ is 100wt%, but is not limited thereto.

In one embodiment, the LVT inorganic material may preferably include SnO (42.5wt%), SnF₂ (40wt%), P₂O₅ (15wt%), and WO₃ (2.5wt%), but is not limited thereto.

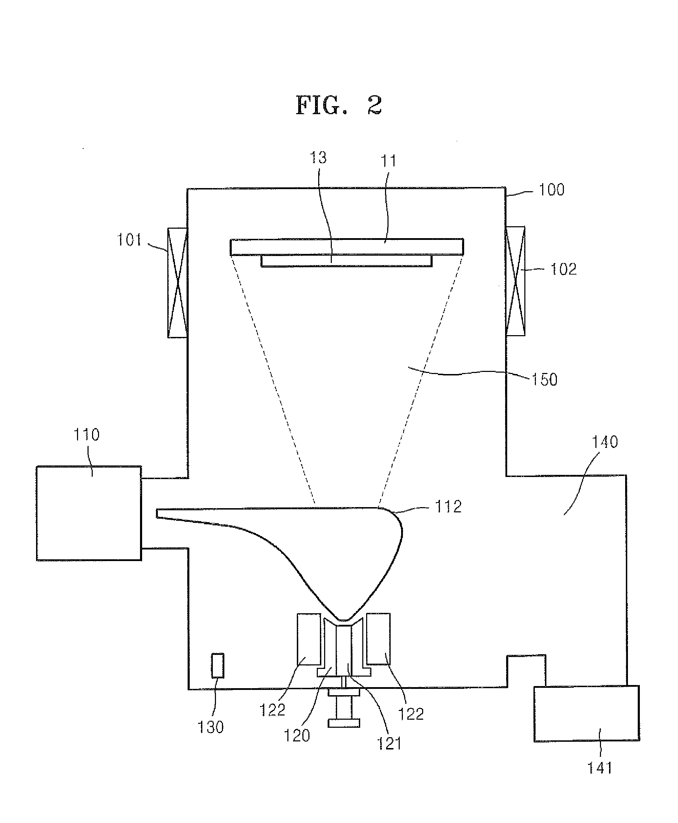

The providing of the LVT inorganic material to the organic emission unit 13 to form the pre-inorganic layer 23 is described below in further detail with reference to FIG. 2.

FIG. 2 is a schematic view of a device used to form the pre-inorganic layer 23 by applying the LVT inorganic material to the organic emission unit 13, according to an embodiment of the present invention.

The device includes a chamber 100 that is maintained in a vacuum and includes a first gate 101 and a second gate 102. The substrate 11 may preferably pass through the chamber 100 via the first gate 101 and the second gate 102.

A plasma gun 110 is preferably disposed at one side of a lower portion of the chamber 100, and a hearth 120 is preferably disposed at a lower portion of the chamber 100. An exhaust pipe 140 and an exhaust pump 141 are preferably disposed at the other side of the lower portion of the chamber 100. A gas injector 130 is preferably disposed to be adjacent to the plasma gun 110. Oxygen and argon gases are preferably injected into the chamber 100 by the gas injector 130 and generate plasma 112 with the plasma gun 110.

In the chamber 100, the plasma 112 is accelerated in a direction toward the hearth 120 preferably by a negative voltage applied to a source 121. A plasma controller 122 is disposed near the hearth 120 to control the migration of the plasma 112. The hearth 120 includes the source 121. Accordingly, the plasma 112 is adjusted to be curved by an angle of 45 to 135 degrees between a region in which the plasma gun 110 is located and a region in which the hearth 120 is located. The migration of the plasma 112 and adjustment of the regions are performed by electric field and magnetic field.

The source 121 contains the LVT inorganic material.

The plasma 112 heats the hearth 120, and due to this heat, the LVT inorganic material, as the source 121 of the hearth 120, is melted or sublimated to form an active region 150, and accordingly, the LVT inorganic material forms a film on the organic emission unit 13.

In this regard, when the hearth 120 is heated and electric charges are accumulated on the upper surface of a tablet, a tablet material is separated therefrom to form a layer on the substrate by a kind of sputtering effect. In general, the amount of electric charges is about several mA and an accelerating voltage is about several kV in sputtering. However, according to the method described above, while the accelerating voltage is about several V, the amount of electric charges is about several A, and thus the speed of a deposition material separated from the source is several hundreds to several thousands times greater than the sputtering. Accordingly, the film-forming speed is several tens to several hundreds times greater than that by general sputtering, and the sputtered particles are deposited on the substrate with an initial constant kinetic energy without any acceleration. Thus, adhesion properties of the pre-inorganic layer 23 to the substrate 11 and the organic emission unit 13 may be improved without damaging the organic emission unit 13.

According to one embodiment, an LVT inorganic material, preferably including SnO-SnF₂-P₂O₅-WO₃ may preferably be provided to the organic emission unit 13 by using the method described above. According to the method, the pre-inorganic layer 23 may be quickly formed without damaging the organic emission unit 13, thereby increasing productivity.

As shown in FIG. 1B, the pre-inorganic layer 23 may include a defect such as a film-forming element 23a, a pin hole 23b, and/or a void 23d formed between the environmental element 15 and the organic emission unit 13.

The film-forming element 23a is an agglomerated particle of the LVT inorganic material that does not contribute to the formation of the LVT inorganic material layer, and the pin hole 23b is a region where the organic emission unit 13 is exposed due to the LVT inorganic material not being applied thereto at the region of the pin hole 23b. The formation of the film-forming element 23a may contribute to the formation of the pin hole 23b. The void 23d formed between the environmental element 15 and the organic emission unit 13 is an empty space at which the LVT inorganic material is not applied.

As described above, any of the defects of the pre-inorganic layer 23 may be a pathway of external environmental materials, such as moisture and oxygen, while the organic light-emitting device is stored or operates to induce the formation of a progressive dark spot, such that a life span of the organic light-emitting device may be reduced.

After the pre-inorganic layer 23 is formed, a healing process that rectifies the defects of the pre-inorganic layer 23 is performed. The healing process, in one embodiment, includes first and second healing processes.

The first healing process is performed at a temperature greater than the viscosity transition temperature of the LVT inorganic material. In one embodiment, the first healing process may preferably be performed by heat-treating the pre-inorganic layer 23 at a temperature in the range of the viscosity transition temperature of the LVT inorganic material to the denaturation temperature of the material contained in the organic emission unit 13. In another embodiment, the first healing process may preferably be performed by heat-treating the pre-inorganic layer 23 at a temperature in the range of the viscosity transition temperature of the LVT inorganic material to a lowest temperature of the denaturation temperatures of the material contained in the organic emission unit 13. In another embodiment, the first healing process may preferably be performed at the viscosity transition temperature of the LVT inorganic material.

The "viscosity transition temperature of the LVT inorganic material" may vary according to the composition of the LVT inorganic material, and the denaturation temperature of the material contained in the organic emission unit 13 and the lowest temperature of the denaturation temperatures of the material contained in the organic emission unit 13 may vary according to the material used in the organic emission unit 13. However, these temperatures will be understood by one of ordinary skill in the art according to the composition of the LVT inorganic material and the material used in the organic emission unit 13, such as by using a Tg evaluation obtained from TGA analysis results of the material contained in the organic emission unit 13.

In one embodiment the first healing process is performed for preferably a period of 0.5 to 5 hours, preferably 1 to 3 hours, and most preferably 2 hours. In one embodiment, the first healing process may preferably be performed by heat-treating the pre-inorganic layer 23 at a temperature of 80°C to 132°C, such as, in the range of 80°C to 120°C, or 100°C to 120°C, for 1 to 3 hours, such as at 110°C for 2 hours, but is not limited thereto. If the temperature of the first healing process is within the range described above, the LVT inorganic material of the pre-inorganic layer 23 may be fluidized, and the denaturation of the organic emission unit 13 may be prevented or substantially prevented.

The first healing process may preferably be performed in a vacuum or in an inert gas atmosphere, such as in an N₂ atmosphere or an Ar atmosphere, using an IR oven in order to prevent or substantially prevent the organic emission unit 13 from being exposed to the external environment.

The LVT inorganic material contained in the pre-inorganic layer 23 may be fluidized by the first healing process. The fluidized LVT inorganic material may have flowability. Thus, in the first healing process at least one of the following may occur:
i) the fluidized LVT inorganic material may flow into the void 23d formed between the environmental element 15 and the organic emission unit 13,
ii) the fluidized LVT inorganic material may flow into the pin hole 23b of the pre-inorganic layer 23, and/or
iii) the film-forming element 23a may be fluidized and flow into the pin hole 23b.

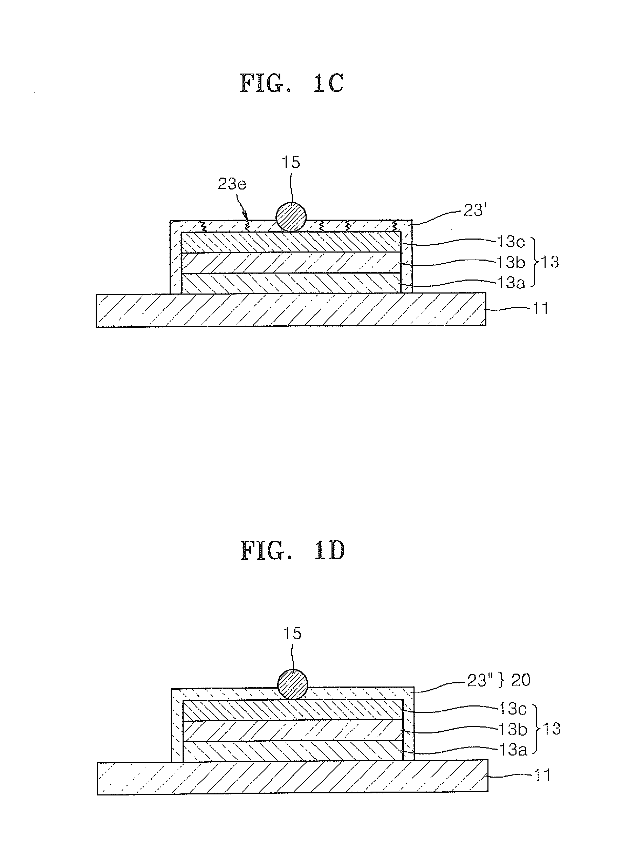

As a result, as shown in FIG. 1C, a pre-inorganic layer 23' rectified by the first healing process is formed, from which the defects of the pre-inorganic layer 23, i.e. the film-forming element 23a, the pin hole 23b, and the void 23d formed between the environmental element 15 and the organic emission unit 13, are removed. In an embodiment of the present invention after any heating steps that cause fluidity the treated layer is solidified.

The pre-inorganic layer 23' rectified by the first healing process may include a region 23e having a weak binding force between the environmental element 15 and the LVT inorganic material or among the LVT inorganic materials. The region 23e having a weak binding force between the environmental element 15 and the LVT inorganic material or among the LVT inorganic materials may be used as a pathway of external environmental materials, such as moisture and oxygen, while the organic light-emitting device is stored or operates to induce the formation of a progressive dark spot, such that the life span of the organic light-emitting device may be reduced.

Thus, in one embodiment, a second healing process is performed to remove the region 23e having a weak binding force between the environmental element 15 and the LVT inorganic material or among the LVT inorganic materials by accelerating vigorous substitution reaction between the environmental element 15 and the LVT inorganic material and among the LVT inorganic materials and improving heat resistance and mechanical strength of the pre-inorganic layer 23' rectified by the first healing process.

The second healing process may preferably be performed by using chemical treatment, plasma treatment, hot chamber treatment including oxygen, or hot chamber treatment including oxygen and moisture.

In one embodiment, the second healing process may preferably be performed by using a chemical treatment by which the pre-inorganic layer 23' is treated with at least one of an acidic solution, an alkaline solution, and a neutral solution. The alkaline solution may preferably be a nitrate solution (e.g., an alkali metal nitrate solution, preferably a potassium nitrate solution).

In one embodiment, the second healing process may preferably be performed by using a plasma treatment by which the pre-inorganic layer 23' is treated using at least one of O₂ plasma, N₂ plasma, and Ar plasma in a vacuum.

In one embodiment, the second healing process may preferably be performed by using a plasma treatment by which the pre-inorganic layer 23' is treated using at least one of O₂ plasma, N₂ plasma, and Ar plasma under atmospheric pressure.

In one embodiment, the second healing process may preferably be performed by exposing the pre-inorganic layer 23' to a chamber having an oxygen partial pressure of 2% to 100%, such as an oxygen partial pressure in the atmospheric pressure, and preferably a temperature of 25°C to 150°C.

In one embodiment, the second healing process may preferably be performed by exposing the pre-inorganic layer 23' to a chamber having an oxygen partial pressure of 2% to 100%, such as an oxygen partial pressure in the atmospheric pressure, a relative humidity of 10% to 100%, and a temperature of 25°C to 150°C.

The oxygen partial pressure is a value with respect to 100% of the pressure in the chamber.

As a result of the second healing process, an inorganic layer 23" is formed, as shown in FIG. 1D, from which the region 23e having a weak binding force between the environmental element 15 and the LVT inorganic material or among the LVT inorganic materials is removed. In addition, the binding force between the inorganic layer 23" and the organic emission unit 13 may preferably be improved by the second healing process, such that a high-quality organic light-emitting device is prepared. In one embodiment, the surface of the inorganic layer 23" is flat.

In one embodiment, the healing process may not include both of the above-described first and second healing processes, and only the first healing process may be performed.

After increasing temperature as described above in the healing process, a cooling process may preferably be performed.

In one embodiment, the healing process may preferably be performed by irradiating laser beams to the pre-inorganic layer 23, and then scanning the pre-inorganic layer 23. That is, the inorganic layer 23" in which various defects are rectified may be formed by increasing a temperature of the pre-inorganic layer 23 by irradiating laser beams to the pre-inorganic layer 23, providing fluidity to the pre-inorganic layer 23, and cooling the pre-inorganic layer 23.

A thickness of the inorganic layer 23" may preferably be 1 µm to 30 µm, such as 1 µm to 5 µm. If the thickness of the inorganic layer 23" is 1 µm to 5 µm, a flexible organic light-emitting device having a bending characteristic may preferably be prepared.

The organic light-emitting device of FIG. 1D includes a thin film encapsulation layer 20 including the inorganic layer 23". By performing the healing process, the inorganic layer 23" is formed having a strong binding force between the environmental element 15 and the LVT inorganic material, among the LVT inorganic materials, and between the LVT inorganic material and the organic emission unit 13, from which the voids formed between the environmental element 15 and the LVT inorganic material and voids formed between the environmental element 15 and the organic emission unit 13 are removed. Since the inorganic layer 23" may be formed in a thin film as described above, a flexible organic light-emitting device having a bending characteristic may be prepared. Accordingly, the organic light-emitting device may have a long life span and excellent flexibility.

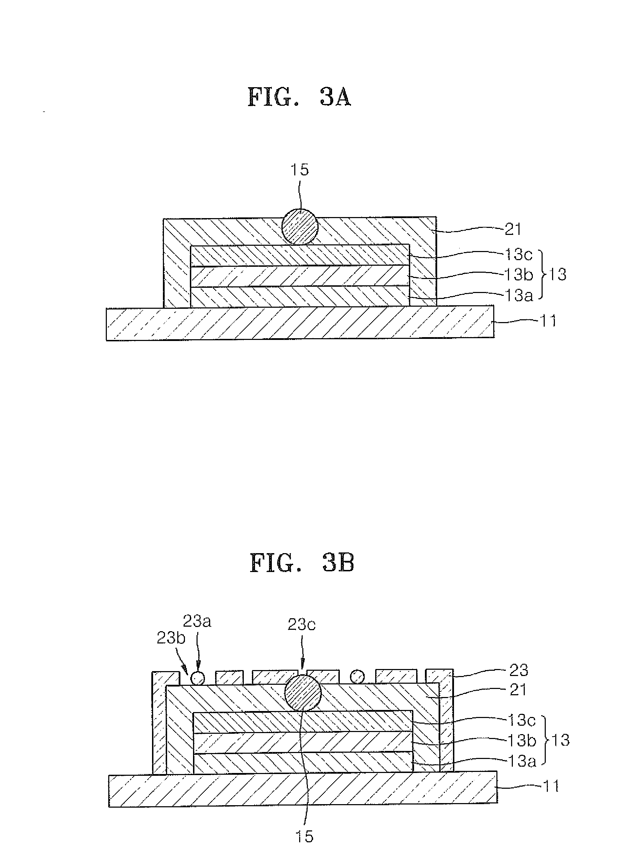

FIGS. 3A to 3D are schematic diagrams illustrating a method of preparing an organic light-emitting device according to another embodiment of the present invention.

As shown in FIG. 3A, the organic emission unit 13 is formed on the substrate 11, wherein the organic emission unit 13 includes the environmental element 15 as described with reference to FIG. 1A, and then an organic layer 21 including a polymer is formed to cover the organic emission unit 13.

The formation of the organic layer 21 may preferably include providing a curable precursor contained in the organic layer 21 and curing the curable precursor.

The precursor may preferably be a thermosetting or photocurable precursor having a viscosity of 5 to 15 cp at room temperature and a boiling point of 300°C to 500°C. In one embodiment, the precursor may preferably be an acrylate precursor such as mono-acrylate, dimethacrylate, and triacrylate, but is not limited thereto. The curable precursor may preferably be a single compound or a mixture of at least two different compounds.

The providing of the curable precursor onto the organic emission unit 13 may preferably be performed by using a flash evaporating method, but is not limited thereto.

Then, the curable precursor provided onto the organic emission unit 13 is cured by using a known method. For example, the precursor may preferably be cured by at least one of UV rays, infrared rays, or laser beams to form the organic layer 21, but is not limited thereto.

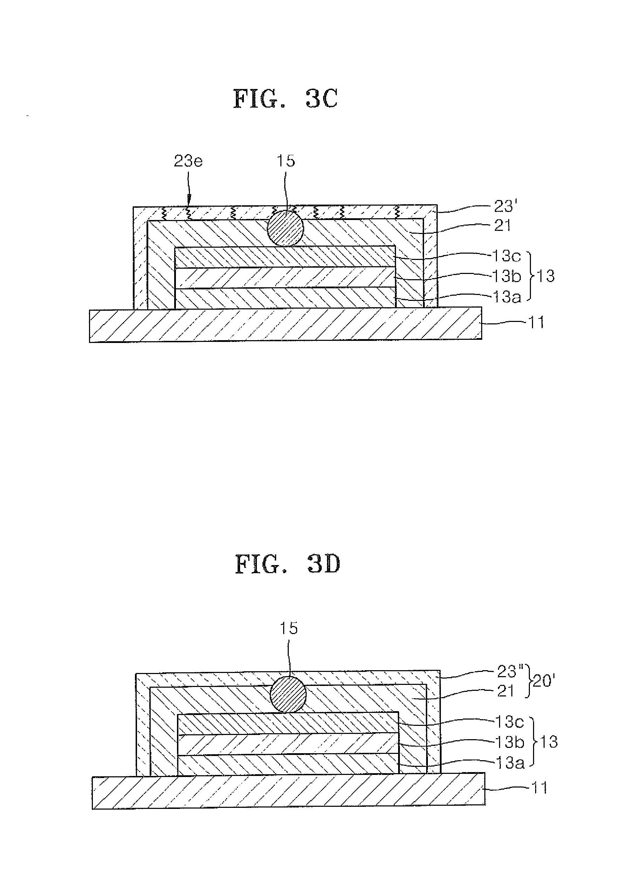

The thickness of the organic layer 21, in one embodiment, is 1 µm to 5 µm. If the thickness of the organic layer 21 is within the range described above, the thin film encapsulation layer 20' (see FIG. 3D) may preferably have a bending characteristic since at least a portion of the environmental element 15 formed on the organic emission unit 13 is covered with the organic layer 21.

In an embodiment of the present invention, the curable precursor is a mixture comprising mono-acrylate, dimethacrylate, and triacryrate. In an embodiment of the present invention the mixture is present in a weight ratio of 0.5-3.5:5.0-9.0:0.2-2.0, preferably 1.0-3.0:6.0-8.0:0.5-1.5, more preferably 2:7:1. According to one embodiment, a curable precursor mixture including mono-acrylate, dimethacrylate, and triacryrate at a weight ratio of about 2:7:1, which has a viscosity of 5 to 15 cp at room temperature, and a boiling point of 300°C to 500°C, may preferably be formed on the organic emission unit 13, as a curable precursor, by using a flash evaporating method (film-forming rate: about 200 Å/s and film-forming time: 3 to 4 min). In one embodiment, the curable precursor mixture is condensed to a liquid phase as soon as the curable precursor mixture is provided onto the organic emission unit 13, and thus at least a portion of the surface of the environmental element 15 is surrounded by the curable precursor without empty space with the environmental element 15. Then, the curable precursor mixture provided onto the organic emission unit 13 is cured to form the organic layer 21 by using a UV curing device (wavelength: 390 nm and light quantity: 500 mJ).

The LVT inorganic material is provided onto the organic layer 21 to form the pre-inorganic layer 23 including the LVT inorganic material as shown in FIG. 3B. As shown in FIG. 3B, the pre-inorganic layer 23 may include a defect such as a film-forming element 23a, a pin hole 23b, or a region 23c through which the environmental element 15 is exposed. As described above, the defect of the pre-inorganic layer 23 may be a pathway of external environmental materials, such as moisture and oxygen, while the organic light-emitting device is stored or operates to induce the formation of a progressive dark spot, such that the life span of the organic light-emitting device may be reduced.

Thus, in one embodiment, after the pre-inorganic layer 23 is formed, a first healing process that rectifies the defect of the pre-inorganic layer 23 is performed.

The first healing process according to one embodiment is as described above.

By the first healing process, as shown in FIG. 3C, a pre-inorganic layer 23' is formed from which the defects of the pre-inorganic layer 23, i.e. the film-forming element 23a, the pin hole 23b, and the region 23c through which the environmental element 15 is exposed are removed.

In one embodiment, the second healing process is performed on the pre-inorganic layer 23'. The second healing process according to one embodiment is as described above.

As a result, as shown in FIG. 3D, an inorganic layer 23" is formed having excellent heat resistance and mechanical strength from which the region 23e having a weak binding force between the environmental element 15 and the LVT inorganic material or among the LVT inorganic materials is removed. In addition, the binding force between the inorganic layer 23" and the organic emission unit 13 may be improved by the second healing process, such that a high-quality organic light-emitting device is prepared. In one embodiment, the surface of the inorganic layer 23" is flat. The healing process, in one embodiment, may include only the first healing process as described above, or may be performed by laser scanning.

The thin film encapsulation layer 20' of FIG. 3D includes one organic layer 21 and one inorganic layer 23", and has a structure in which the organic layer 21 and the inorganic layer 23" are sequentially stacked on the organic emission unit 13. Since the thin film encapsulation layer 20' of FIG. 3D may considerably reduce a takt time by forming the inorganic layer 23" after forming the organic layer 21 having a thickness (e.g., a predetermined thickness), compared with the thin film encapsulation layer 20 including only the inorganic layer 23" as shown in FIG. 1D, such that mass productivity may be improved. In addition, the thin film encapsulation layer 20' of FIG. 3D may have an excellent bending characteristic since the organic layer 21 may have a better bending characteristics than the inorganic layer 23". The thin film encapsulation layer 20' of FIG. 3D has excellent sealing characteristics due to the inorganic layer 23".

A thickness of the thin film encapsulation layer 20' of FIG. 3D, in one embodiment, is greater than an average particle diameter of the environmental element 15. Thus, in one embodiment, the environmental element 15 is covered by the thin film encapsulation layer 20', and thus a possibility of generation of a progressive dark spot caused by exposure of the environmental element 15 may be reduced or eliminated.

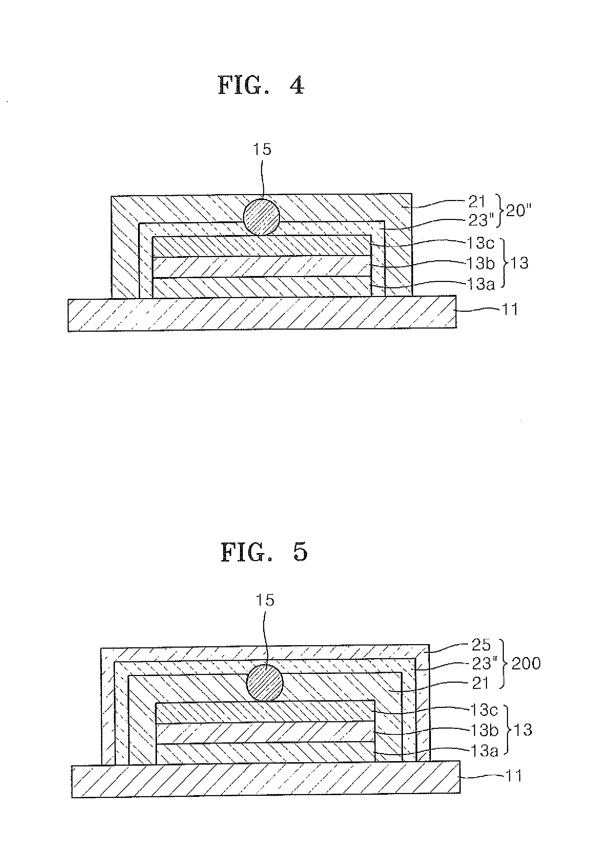

An organic light-emitting device shown in FIG. 4 has a same structure as the organic light-emitting device of FIG. 3D, except that the organic light-emitting device of FIG. 4 includes a thin film encapsulation layer 20" including one inorganic layer 23" and one organic layer 21 which are sequentially stacked on the organic emission unit 13.

The organic light-emitting device of FIG. 4, in one embodiment, is prepared in the same manner as in preparation of the organic light-emitting device of FIG. 3D, except that the inorganic layer 23" is formed on the organic emission unit 13, and then the organic layer 21 is formed thereon.

In the thin film encapsulation layer 20" of FIG. 4, the organic layer 21 formed on the external surface of the inorganic layer 23" protects the inorganic layer 23" from external impact and compensates for bending characteristics of the inorganic layer 23", and the inorganic layer 23" may provide excellent sealing characteristics for a long period of time as described above. Furthermore, by forming the organic layer 21, the environmental element 15, at least a portion of which is exposed outside of the inorganic layer 23", may be completely covered by the thin film encapsulation layer 20". Thus, a possibility of generation of a progressive dark spot caused by exposure of the environmental element 15 may be reduced or eliminated. A thickness of the thin film encapsulation layer 20" of FIG. 4, in one embodiment, is greater than an average particle diameter of the environmental element 15.

The organic light-emitting device according to embodiments of the present invention may include a thin film encapsulation layer including a plurality of inorganic layers and/or a plurality of organic layers. If the thin film encapsulation layer includes a plurality of inorganic layers and/or a plurality of organic layers, the plurality of inorganic layer and/or the plurality of organic layers may preferably be alternately stacked on each other.

In one embodiment, an organic light-emitting device shown in FIG. 5 has a same structure as the organic light-emitting device shown in FIG. 3D, except that the organic light-emitting device of FIG. 5 includes a thin film encapsulation layer 200 that includes two organic layers, i.e. a first organic layer 21 and a second organic layer 25, and one inorganic layer 23", wherein the first organic layer 21, the inorganic layer 23", and the second organic layer 25 are sequentially stacked on the organic emission unit 13.

In one embodiment, the first organic layer 21 and the second organic layer 25 and a method of preparing the same are as described above with reference to FIG. 3A. The second organic layer 25 may preferably be formed by using screen printing, inkjet printing, spin coating, or the like, and various modifications may be made. The organic materials used to form the first organic layer 21 and the second organic layer 25 may preferably be the same or different. In one embodiment, the inorganic layer 23" and a method of preparing the same are as described above with reference to FIGS. 1 B to 2.

The first organic layer 21 and the second organic layer 25 of the thin film encapsulation layer 200 of FIG. 5 compensate for a poor bending characteristic of the inorganic layer 23", and the second organic layer 25 formed on an external surface of the inorganic layer 23" may protect the inorganic layer 23" from external impact.

A thickness of the thin film encapsulation layer 200 of FIG. 5, in one embodiment, is greater than an average particle diameter of the environmental element 15.

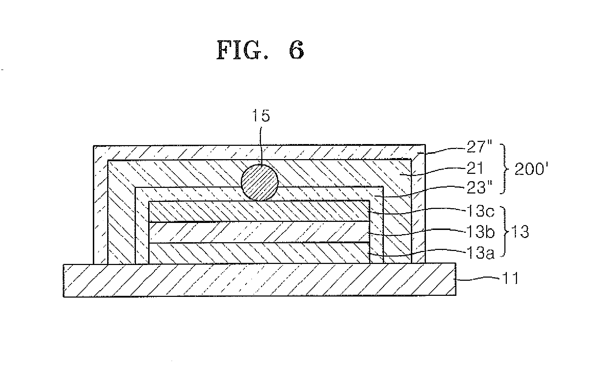

In one embodiment, an organic light-emitting device shown in FIG. 6 has a same structure as the organic light-emitting device shown in FIG. 3D, except that the organic light-emitting device of FIG. 6 includes a thin film encapsulation layer 200' that includes one organic layer 21 and two inorganic layers, i.e. a first inorganic layer 23" and a second inorganic layer 27", wherein the first inorganic layer 23", the organic layer 21, and the second inorganic layer 27" are sequentially stacked on the organic emission unit 13. In one embodiment, the first inorganic layer 23" and the second inorganic layer 27" of the organic light-emitting device of FIG. 6 and a method of preparing the same are as described above with reference to FIGS. 1B to 2. The second inorganic layer 27" may preferably also be formed of a different inorganic material from the first inorganic layer 23" such as silicon-based oxide, silicon-based nitride, aluminum-based oxide, and/or aluminum-based nitride, and various modifications may be made. In one embodiment, the organic layer 21 and a method of preparing the same are as described above with reference to FIG. 3A.

The organic light-emitting devices including a thin film encapsulation layer including a plurality of inorganic layers and/or a plurality of organic layers, according to embodiments of the present invention, are described above with reference to FIGS. 5 and 6. However, various modifications can be made referring to FIGS. 5 and 6. For example, the thin film encapsulation layer may preferably include a first inorganic layer, a first organic layer, a second inorganic layer, and a second organic layer which are sequentially stacked.

In the organic light-emitting devices shown in FIGS. 1A to 6, the thin film encapsulation layer is formed to cover the organic emission unit 13, but the location of the thin film encapsulation layer is not limited thereto.

In one embodiment, the thin film encapsulation layer shown in FIGS. 1D, 3D, 4, 5, and 6 may preferably be formed under the substrate 11. If the substrate 11 is a TFT substrate, the TFT is sealed from the external environment by the thin film encapsulation layer, such that the organic light-emitting device may have a long life span and flexibility.

In one embodiment, the thin film encapsulation layer shown in FIGS. 1D, 3D, 4, 5, and 6 may preferably be formed between the organic emission unit 13 and the substrate 11. Accordingly, a pixel circuit including a TFT and/or a capacitor may preferably be formed on the thin film encapsulation layer.

While the present invention has been particularly shown and described with reference to some embodiments thereof, it will be understood by those of ordinary skill in the art that various changes in form and details may be made therein without departing from the scope of the present invention as defined by the following claims.

## Claims

1. A method of preparing an organic light-emitting device, the method comprising:
forming an organic emission unit on a substrate; and
forming a thin film encapsulation layer including at least one inorganic layer including a low temperature viscosity transition (LVT) inorganic material, the forming the thin film encapsulation layer comprising forming the at least one inorganic layer,
wherein the forming the at least one inorganic layer comprises:
forming a pre-inorganic layer including the LVT inorganic material on the organic emission unit by heating a source comprising the LVT inorganic material using plasma in a vacuum and depositing the LVT inorganic material or ions of the LVT inorganic material separated from the source on the organic emission unit; and
applying a healing process to the pre-inorganic layer at a temperature greater than a viscosity transition temperature of the LVT inorganic material.

2. The method of claim 1, wherein the viscosity transition temperature of the LVT inorganic material is a minimum temperature capable of providing fluidity to the LVT inorganic material.

3. The method of claim 1 or claim 2, wherein the viscosity transition temperature of the LVT inorganic material is less than a lowest temperature of denaturation temperatures of materials contained in the organic emission unit.

4. The method of any of claims 1 to 3, wherein the LVT inorganic material comprises a tin oxide.

5. The method of claim 4, wherein the LVT inorganic material further comprises at least one selected from the group consisting of phosphorus oxide, boron phosphate, tin fluoride, niobium oxide, and tungsten oxide.

6. The method of any of claims 1 to 3, wherein the LVT inorganic material comprises SnO; SnO and P₂O₅; SnO and BPO₄; SnO, SnF₂, and P₂O₅; SnO, SnF₂, P₂O₅, and NbO; or SnO, SnF₂, P₂O₅, and WO₃.

7. The method of any of claims 1 to 6, wherein the applying the healing process is performed by heat-treating the pre-inorganic layer at a temperature from the viscosity transition temperature of the LVT inorganic material to a lowest temperature of denaturation temperatures of materials contained in the organic emission layer.

8. The method of any of claims 1 to 7, wherein the applying the healing process is performed by heat-treating the pre-inorganic layer at a temperature of 80°C to 132°C for 1 to 3 hours.

9. The method of any of claims 1 to 8, wherein the applying the healing process is performed in a vacuum or in an inert gas atmosphere.

10. The method of any of claims 1 to 9, wherein the applying the healing process comprises scanning the pre-inorganic layer while irradiating a laser beam to the pre-inorganic layer.

11. The method of any of claims 1 to 10, wherein the forming the thin film encapsulation layer further comprises forming at least one organic layer of the thin film encapsulation layer, the at least one organic layer including a polymer.

12. The method of claim 11, wherein the forming the at least one organic layer comprises providing a curable precursor, and curing the curable precursor.

13. The method of claim 12, wherein the providing the curable precursor is performed by using a flash evaporator.

14. The method of claim 12 or claim 13, wherein the curing the curable precursor is performed by using at least one of UV rays, infrared rays, or laser beams.

15. The method of any of claims 11 to 14, wherein the thin film encapsulation layer comprises one organic layer and one inorganic layer, wherein the organic layer and the inorganic layer or the inorganic layer and the organic layer are sequentially stacked on the organic emission unit.

16. The method of any of claims 11 to 15, wherein the thin film encapsulation layer comprises two organic layers including first and second organic layers, and one inorganic layer, wherein the first organic layer, the inorganic layer, and the second organic layer are sequentially stacked on the organic emission unit or wherein the thin film encapsulation layer comprises one organic layer, and two inorganic layers including first and second inorganic layers, wherein the first inorganic layer, the organic layer, and the second inorganic layer are sequentially stacked on the organic emission unit.

17. The method of claim 1, wherein the forming the pre-inorganic layer comprises applying a negative potential to the substrate.

18. The method of any of claims 1 to 17, wherein the forming the at least one inorganic layer further comprises applying another healing process to the pre-inorganic layer subsequent to the first healing process by using chemical treatment, plasma treatment, hot chamber treatment including oxygen, or hot chamber treatment including oxygen and moisture.

19. An organic light-emitting device produced by the method of any of claims 1 to 18.
